# EUROPEAN PATENT APPLICATION

(11) **EP 1 928 021 A1**
(43) Date of publication of application: **04.06.2008**
(21) Application number: 07075957.6
(22) Date of filing: 05.11.2007
(51) Int. Cl.: H01L 21/8238

(54) **Method of manufacturing a semiconductor device with dual fully silicided gate**

(30) Priority: 29.11.2006 US 861749 P
(71) Applicant: Interuniversitair Microelektronica Centrum (IMEC), 3001 Leuven (BE); Taiwan Semiconductor Manufacturing Co., Ltd., 300-077 HsinChu (TW)
(72) Inventor: Yu, Hong Yu, 3001 Leuven (BE); Chang, Shou-Zen, 3080 Tervuren (BE)
(74) Representative: Bird, William Edward

(57) **Abstract**

Manufacturing a dual work function semiconductor device involves providing a first metal layer (108) over a first electrode (102a) in a first region (101a), and at least a first work function tuning element. Also provided is a second metal layer (109) of a second metal in a second region (101b) at least over a second electrode (102b). A first silicidation of the first electrode (102a) and a second silicidation of the second electrode (102b) are performed simultaneously.

## Description

### Field of the invention

The present invention generally relates to the field of semiconductor process technology and semiconductor devices. More specifically, this invention relates to the fabrication of semiconductor devices with fully silicided gates and dual work function.

### Background of the invention

Up to now, semiconductor industry remains driven by scaling the geometric dimensions of the metal-oxide-semiconductor field-effect-transistor (MOSFET). With traditional MOSFET-technology, using silicon dioxide (SiO₂) as gate dielectric and polycrystalline silicon (poly-Si) as gate material, a lot of problems occur when scaling down to 100 nm or below.

As the gate oxide thickness is reduced, an exponential increase of the gate direct tunneling currents occurs. One solution to solve this problem for the 45 nm node and beyond is the introduction of so-called high-k dielectrics as gate dielectric. A high-k dielectric is a dielectric featuring a dielectric constant (k) greater than the dielectric constant of SiO₂, i.e. k > 3.9. High-k dielectrics allow for a larger physical thickness (compared to SiO₂) for the same effective capacitance as a much thinner SiO₂ layer. The larger physical thickness of the high-k material will reduce the gate leakage currents.

Together with the gate dielectric scaling, also the gate dimensions are scaled down. However for SiO₂ oxide thicknesses below 2 nm polydepletion starts to become dominant in the poly-Si gate. A solution to solve this problem is the introduction of metals as gate material. Metal gates offer the advantages of eliminating the polysilicon gate depletion effect, reducing the sheet resistance, better compatibility with high-k gate dielectrics and controlling the work function independently from the doping of the junction regions.

However, by introducing metal gates, the threshold voltage becomes controlled by the metal work function. The fabrication of MOSFETs (both nMOSFET and pMOSFET) with metal gates comparable to polysilicon gate MOSFETs has remained a huge challenge to industry researchers, because the effective work function of metal electrodes is affected by several factors, including composition, underlying dielectric and heat cycles during processing.

Regarding metal gate electrodes, tuning of the work function is not straightforward as a dual (symmetric) work function is necessary for NMOS and PMOS. Whereas the work function of a poysilicon gate electrode can be tuned by ion implantation, the work function of a metal gate electrode is a material property which cannot be changed easily.

Depending on the requirements for the work function of the metal gates,'several integration schemes are possible to integrate metal gates into a CMOS process flow such as using fully-silicided metal gates (FUSI).

FUSI gate contacts are formed by a (full) silicidation of a semiconductor gate contact with a metal. This means that the semiconductor gate contact is completely converted into a gate silicide. Silicidation is defined as the annealing process resulting in the formation of a metal-semiconductor alloy (a silicide) to act as a contact in a semiconductor device. The semiconductor gate contact may be a poly-silicon contact. The metal may be a refractory metal such as tungsten (W), a noble metal such as platinum (Pt), a near-noble metal such as nickel (Ni), a transition metal such as titanium (Ti), or any combination thereof. So silicides are formed by depositing a metal, such as Ni, on top of the gate silicon (Si), followed by a thermal step (such as rapid thermal processing (RTP)) to create a silicide, for example NiSi. In the FUSI approach, this step is continued until all of the gate silicon is converted into a silicide.

One possible solution to tune the work function in a FUSI gate CMOS is by using different Ni-silicide phases (NiSi for NMOS and Ni-rich silicide for PMOS), as presented by A. Lauwers et al. in 'CMOS integration of dual work function phase controlled Ni FUSI with simultaneous silicidation of NMOS (NiSi) and PMOS (Ni-rich silicide) gates on HfSiON' (IEDM 2005, p.661). By using a 2-step Ni FUSI process a simultaneous full silicidation of NMOS and PMOS are achieved with different Ni/Si ratios on NMOS and PMOS by reduction of the PMOS poly height through a selective and controlled poly etch back prior to gate silicidation.

Another possibility to tune the work function in a FUSI gate CMOS is by using different metal materials (with different work function) in NMOS and PMOS. In the US application US2006/012,663 a method is described of forming a dual self-aligned fully silicided gate in a CMOS device. In this method a blocking film is deposited over both NMOS and PMOS. After patterning the blocking film, a first metal layer is deposited to form a first FUSI gate on the NMOS with a first metal. After removal of the un-reacted first metal, a second metal layer is deposited to form the FUSI PFET. With this method the PMOS FUSI gate region is formed of a different material than the NMOS FUSI gate region by using two separate silicidation steps.

There is a need for other possibilities to manufacture dual FUSI semiconductor devices. More specifically there is a need for dual FUSI CMOS devices manufactured using a simple integration flow (i.e. a minimum of process steps) combined with a need for tuning the work function for NMOS and/or PMOS.

### Summary of the Invention

The aim of certain inventive aspects is to provide good methods for manufacturing semiconductor devices, more specifically dual work function semiconductor devices with dual fully silicided metal gates (FUSI).

One inventive aspect relates to a method of manufacturing a dual work function semiconductor device comprising the steps of providing at least a first region in a semiconductor substrate comprising at least a first electrode; providing at least a second region in the semiconductor substrate comprising at least a second electrode; providing a first metal layer over the first electrode in the first region, the first metal layer comprising at least a first metal and at least a first work function tuning element; providing a second metal layer in the second region at least over the second electrode, the second metal layer comprising at least a second metal and performing a first silicidation of the first electrode and performing a second silicidation of the second electrode wherein the first silicidation and the second silicidation are performed simultaneously.

It is an advantage of certain inventive aspects that dual fully silicided (FUSI) electrodes may be manufactured for both an at least first electrode in a first region and an at least second electrode in a second region of a semiconductor device during one simultaneous silicidation process.

It is another advantage of certain inventive aspects that dual fully silicided (FUSI) electrodes may be manufactured for both an at least first electrode in a first region and an at least second electrode in a second region of a semiconductor device whereby forming different silicided electrodes simultaneously. More specifically a first silicided electrode in a first region of the semiconductor device and a second silicided electrode in a second region of the semiconductor device are formed simultaneously using one occurring silicidation process. The silicided electrode may be formed by silicidation of a polysilicon electrode using a metal layer. The metal layer comprises at least a metal suitable for silicidation. The metal layer may comprise at least a work function tuning element suitable for tuning the work function of the electrode.

As an additional feature the second metal layer may further comprise at least a second work function tuning element, the second work function tuning element being different from the first work function tuning element.

Optionally the first metal of the first metal layer and the second metal of the second metal layer may be the same.

It is another advantage of certain inventive aspects that the work function for both a first region and a second region of a semiconductor device may be modulated from midgap to n-type band-edge and/or from midgap to p-type band-edge respectively.

The step of providing a first metal layer may comprise providing a patterned first metal layer covering at least the first electrode in the first region but not covering the second electrode in the second region.

The step of providing a patterned first metal layer may comprise depositing a first metal layer covering the first electrode in the first region and the second electrode in the second region; patterning the first metal layer hereby removing part of the first metal layer in the second region covering the second electrode.

The step of patterning the first metal layer may comprise providing a photoresist layer covering the first electrode in the first region and the second electrode in the second region after the step of depositing a first metal layer; performing a lithographic step hereby removing at least part of the photoresist layer covering the second electrode in the second region and etching the first metal layer in the second region at least covering the second electrode.

A hardmask layer may be provided on the first metal layer before the step of providing a photoresist layer. Part of the hardmask layer in the second region covering the second electrode is etched before etching the first metal layer.

Alternatively the step of providing a patterned first metal layer may comprise providing a sacrificial layer covering at least the first electrode in the first region and the second electrode in the second region; patterning the sacrificial layer such that the patterned sacrificial layer covers at least the second electrode in the second region but not the first electrode in the first region; providing a first metal layer covering the first electrode in the first region and covering the patterned sacrificial layer covering the second electrode in the second region; and patterning the first metal layer.

Patterning the sacrificial layer may comprise providing a photoresist layer on the sacrificial layer covering the first electrode in the first region and the second electrode in the second region; performing a lithographic step, hereby removing part of the photoresist layer in the first region at least covering the first electrode; and removing part of the sacrificial layer in the first region at least covering the first electrode.

The sacrificial layer may be lifted off in the second region covering the second electrode, hereby also removing the first metal layer in the second region covering the second electrode in the step of patterning the first metal layer.

Providing a second metal layer comprises covering at least the first electrode and the second electrode with the second metal layer.

The first metal from the first metal layer and/or the second metal from the second metal layer may comprise at least a metal selected from the group of Ni, Co, Ti. The first metal from the first metal layer and/or the second metal from the second metal layer comprise at least a material suitable for silicidation of the underlying first electrode and/or second electrode respectively.

The first work function tuning element from the first metal layer or the second work function tuning element from the second metal layer may comprise an element from the lanthanide group.

The first work function tuning element from the first metal layer or the second work function tuning element from the second metal layer can be selected from the group of Yb, Tb, Gd, La, Er, Dy.

The first work function tuning element from the first metal layer or the second work function tuning element from the second metal layer can comprise a platinum metal.

The first work function tuning element from the first metal layer or the second work function tuning element from the second metal layer can be selected from the group of Pt, Pd, Ir, Ru, Rh, Os.

The first work function tuning element from the first metal layer or the second work function tuning element from the second metal layer can comprise Al.

One inventive aspect relates to a method of manufacturing a dual work function semiconductor device according to any of the previous claims, the semiconductor device being a CMOS device, wherein the first region and the second region have an opposite doping type.

The doping type of first region may be n-type.

It is an advantage of certain inventive aspects that the work function of the electrode can be modulated in a much wider range by using an alloy approach, which comprises performing a simultaneous silicidation step for siliciding the first electrode using a first metal material or metal alloy and for siliciding the second electrode using a second metal material or metal alloy. The first and second metal material are chosen such that the work function of the electrode may be tuned to a higher or lower work function depending on the majority carriers of the device. Tuning of the work function is done by choosing the appropriate work function tuning element.

### Brief Description of the Drawings

All drawings are intended to illustrate some aspects and embodiments of the present invention. The drawings described are only schematic and are non-limiting. In the drawings, the size of some of the elements may be exaggerated and not drawn on scale for illustrative purposes.

Exemplary embodiments are illustrated in referenced figures of the drawings. It is intended that the embodiments and figures disclosed herein be considered illustrative rather than restrictive.

Figure 1 is a schematic representation of a dual work function semiconductor device obtained by means of a method according to a particular embodiment of the present invention.

Figures 2A-2G are schematic representations of the different steps according to a particular embodiment of the present invention.

Figures 3A-3C are schematic representations of method steps for providing a first metal according to a particular embodiment of the present invention.

Figures 4A-4I are schematic representations of the different steps according to another particular embodiment of the present invention.

Figures 5A-5H are schematic representations of the different steps according to another particular embodiment of the present invention.

Figures 6A-6B show experimental results for the work function of a semiconductor device manufactured according to embodiments of the present invention.

Figure 7 is a flow chart illustrating different method steps.

### Detailed description

One or more embodiments of the present invention will now be described in detail with reference to the attached figures, the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention. Those skilled in the art can recognize numerous variations and modifications of this invention that are encompassed by its scope. Accordingly, the description of preferred embodiments should not be deemed to limit the scope of the present invention.

Furthermore, the terms first, second and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein. For example "underneath" and "above" an element indicates being located at opposite sides of this element.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

In the following certain embodiments will also be described with reference to a silicon substrate but it should be understood that certain inventive aspects apply equally well to other semiconductor substrates. In embodiments, the "substrate" may include a semiconductor substrate such as e.g. a silicon, a gallium arsenide (GaAs), a gallium arsenide phosphide (GaAsP), an indium phosphide (InP), a germanium (Ge), or a silicon germanium (SiGe) substrate. The "substrate" may include for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. Accordingly a substrate may be a wafer such as a blanket wafer or may be a layer applied to another base material, e.g. an epitaxial layer grown onto a lower layer.

Some embodiments are suitable for integration into CMOS processing to provide CMOS devices. In such processing active regions can be formed by doping a semiconductor layer. An active region is defined as any region which becomes active due to the implantation of a dopant such as As, B, Ph, Sb, etc. In a MOS device this active region is often referred to as source and/or drain region. However certain inventive aspects are not limited thereto.

In the following certain embodiments will be described with reference devices structures such as complementary metal oxide semiconductor (CMOS) devices, having a drain, source and gate but the inventive aspect is not limited thereto. For example the embodiments may be applied to planar CMOS devices as well as to multi-gate field effect transistors (e.g. FINFET devices).

The method described herein may be used in many methods for fabricating semiconductor devices. One example is the manufacture of semiconductor devices comprising different semiconductor structures, each having a control electrode, for example gate electrode, and at least two main electrodes, for example a source and a drain electrode. In the description hereinafter, a method is described for the manufacturing of a dual work function semiconductor device having two semiconductor structures, each with a gate electrode as control electrode and a source and a drain region as first and second main electrodes. This example is used only for the ease of explanation and is not intended to be limiting for the invention.

In this description, the terms 'silicidation', 'silicide', 'silicided' refer to the reaction between a semiconductor and a metal. Silicidation is defined as the annealing process resulting in the formation of a metal-semiconductor alloy (a silicide) to act as a contact in a semiconductor device and to provide a lower resistance. The semiconductor gate contact may be a poly-silicon contact, but is not limited thereto. The semiconductor gate contact may be for example germanium (Ge) or any other suitable semiconductor. The metal may be a refractory metal such as tungsten (W), a noble metal such as platinum (Pt), a near-noble metal such as nickel (Ni), a transition metal such as titanium (Ti), or any combination thereof. So silicides are formed by depositing a metal, such as for example Ni, on top of for example the polysilicon gate, followed by at least one thermal step (such as rapid thermal processing (RTP)) to create a silicide, such as for example NiSi. In the fully-silicided (FUSI) approach, this step is continued until all of the gate silicon is converted to a silicide.

One embodiment provides a method for manufacturing a dual work function semiconductor device comprising providing at least a first region (101a) in a semiconductor substrate (100) comprising at least a first electrode (102a); providing at least a second region (101b) in the semiconductor substrate (100) comprising at least a second electrode (102b); providing a first metal layer (108) over the first electrode (102a) in the first region (101a), the first metal layer comprising at least a first metal and at least a first work function tuning element; providing a second metal layer (109) in the second region (101b) at least over the second electrode (102b), the second metal layer (109) comprising at least a second metal; performing a first silicidation of the first electrode (102a) and performing a second silicidation of the second electrode (102b) wherein the first silicidation and the second silicidation are performed simultaneously.

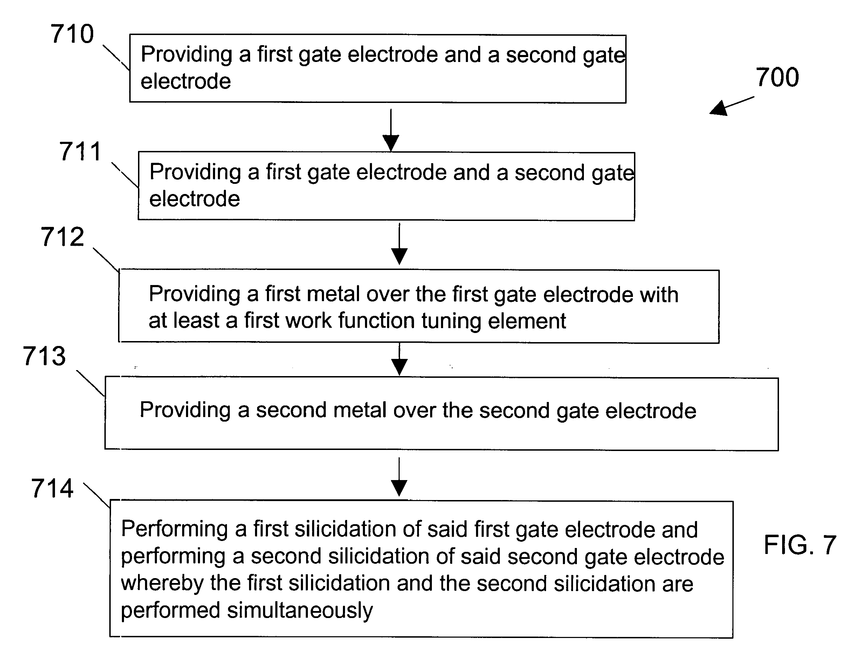

A method for manufacturing a dual work function semiconductor device according to embodiments of the present invention is shown in a flow chart in FIG. 7, illustrating different steps.

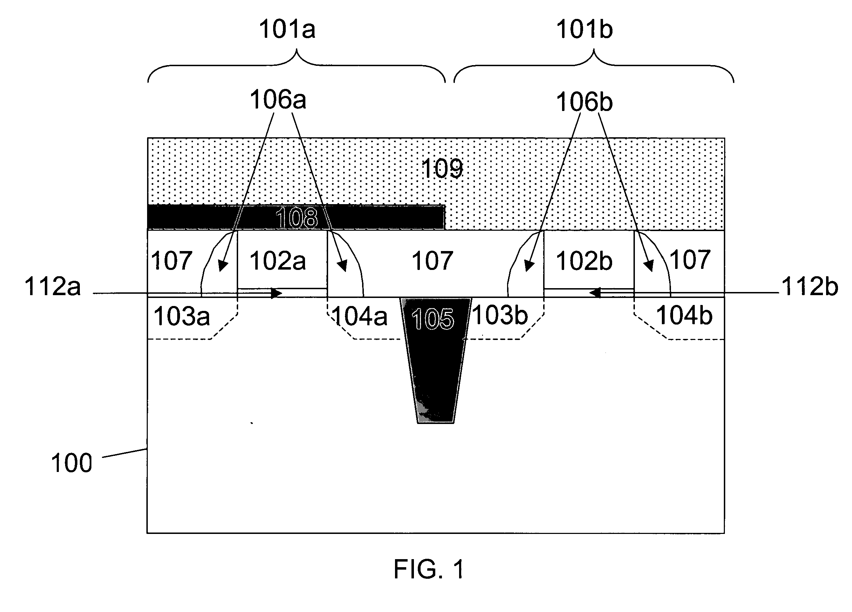

A first step (710) may comprise providing at least a first gate electrode in a semiconductor substrate. The substrate 100 may be any type of substrate 100 as described above. Preferably, the substrate 100 may comprise multiple distinct regions. Most preferably two distinct regions may be defined in the substrate 100, as is illustrated in Fig. 1: a first region 101a (left-hand as viewed) and a second region 101b (right-hand as viewed). The second region 101b is distinct and not overlapping with the first region 101a. The first region 101a may present, for example, an NMOS region of the semiconductor device; the second region 101b may present, for example, a PMOS region of the semiconductor device; or vice versa. A possible way to isolate the first 101a and second 101b region from each other is by using shallow trench isolation (STI) 105 in between. STI is a deep narrow trench, filled with oxide, etched into the semiconductor substrate in between adjacent devices in an integrated circuit to provide electrical isolation between. Alternatively, local oxidation of silicon (LOCOS) may be used.

A first gate electrode 102a is provided in the first region 101a. Alternatively a first source region 103a and a first drain region 104a may be provided in the first region 101a (FIG. 1). The first gate electrode 102a, is advantageously formed from a polysilicon layer. Alternatively the first gate electrode 102a may comprise another semiconductor element such as for example Ge. The first source region 103a is the region which will inject majority carriers (e.g. electrons for NMOS or holes for PMOS) into the channel region located underneath the first gate electrode 102a, whereas the first drain region 104a is the region which will collect the majority carriers (e.g. electrons for NMOS or holes for PMOS) coming from the channel region located underneath the first gate electrode 102a. Advantageously the first source 103a/drain 104a region is formed by ion implantation. Alternatively the source 103a/drain 104a region may also be a recessed source/drain by using in-situ doped SiGe.

A second step (711) may comprise providing at least a second gate electrode in the semiconductor substrate. The second gate electrode 102b is formed in a second region 101b of the semiconductor substrate 100. The second gate electrode 102b is advantageously formed from a polysilicon layer. Alternatively the second gate electrode 102b may comprise another semiconductor element such as for example Ge. Alternatively also a second source region 103b and a second drain region 104b may be provided in the second region 101b (FIG. 1). The second source region 103b is the region which will inject majority carriers (e.g. electrons for NMOS and holes for PMOS) into the channel region located underneath the second gate electrode 102b, whereas the second drain region 104b is the region which will collect the majority carriers (e.g. electrons for NMOS and holes for PMOS) coming from the channel region located underneath the second gate region 102b. Advantageously the first source 103b/drain 104b region is formed by ion implantation. Alternatively the source 103a/drain 104a region may also be a recessed source/drain by using in-situ doped SiGe.

Additionally a gate dielectric 112a 112b may be formed prior to the step of forming the first/second gate electrode 102a 102b. A gate dielectric layer may be a layer of insulating material, such as for example silicon dioxide (Si02), silicon nitride (SiN) or silicon oxynitride (SiₓO_{y}N_{1-x-y}) or a high-k dielectric material (i.e. k > 3.9) such as for example HfO₂, TaOₓ, Al₂O₃. A gate dielectric material may be formed by thermal oxidation or chemical vapor deposition (CVD), or any other suitable method known to a person skilled in the art.

Additionally spacers 106a 106b may be formed in the first region 101a and/or in the second region 101b at the sidewalls of the first 102a and second 102b gate electrode (FIG. 1). Spacers are formed from an insulating material such as for example silicon dioxide (SiO₂), silicon nitride (SiN) or silicon oxynitride (SiON). Spacers may be deposited by CVD and patterned by anisotropic etching, or any other suitable method known to a person skilled in the art.

Additionally an insulating layer 107 is formed on both the first 101a and second 101b region (FIG. 1). More specifically the insulating layer 107 is formed above the first and second source/drain regions and planar with the first and second gate electrodes. The insulating layer may comprise preferably oxide such as for example silicon dioxide (SiO₂). The insulating layer may also be nitride such as for example silicon nitride (SiN) or silicon oxynitride (SiON). The insulating layer may be preferably formed using a deposition technique such as for example chemical vapor deposition (CVD). Alternatively the insulating layer may be an etch stop layer (ESL). The insulating layer will prevent the source and drain regions from silicidation during the subsequent silicidation steps.

A third step (712) may comprise providing a first metal layer 108 over the first gate electrode 102a, the first metal layer 108 comprising at least a first metal and at least a first work function tuning element. The first metal layer 108 is thus formed over the first gate electrode 102a in the first region 101a and over at least part of the insulating layer 107 in the first region 101a. The first metal layer 108 is preferably deposited using physical vapor deposition (PVD) or any other suitable deposition technique known for a person skilled in the art

A fourth step (713) may comprise providing a second metal layer 109 over at least the second gate electrode 102b, the second metal layer comprising at least a second metal. The second metal layer 108 is thus formed over the second gate electrode 102a in the second region 101a and over at least part of the insulating layer 107 in the second region 101a. The second metal layer 109 is preferably deposited using physical vapor deposition (PVD) or any other suitable deposition technique known for a person skilled in the art.

According to an embodiment, the second metal layer 109 may further comprise at least a second work function tuning element whereby the second work function tuning element is different from the first work function tuning element of the first metal layer.

According to an embodiment, the second metal layer 109 may comprise the same metal material as the first metal layer 108.

A fifth step (714) may comprise performing a first silicidation of said first gate electrode and performing a second silicidation of said second gate electrode whereby the first silicidation and the second silicidation are performed simultaneously. With simultaneously is meant that the silicidation of the first gate electrode 102a and of the second gate electrode 102b is performed at the same time. Otherwise said this means that the silicidation of the first gate electrode 102a and of the second gate electrode 102b is not formed in subsequent steps but during one occurring step.

Preferably, the silicidation step is such as to obtain a fully silicided gate electrode (FUSI). The step of fully siliciding the semiconductor material (e.g. initial polysilicon gate electrode) may comprise the step of providing a thermal budget (e.g. rapid thermal processing (RTP)) to convert substantially all the semiconductor material of the gate electrode into silicide and the step of removing any unreacted material. Alternatively, the step of fully siliciding the semiconductor material may comprise the step of providing a first thermal budget (e.g. RTP1) to convert partially the semiconductor material into silicide, the step of removing any unreacted material, and the step of providing a second thermal budget (e.g. RTP2) for completion of the conversion of the semiconductor material into silicide.

The present invention will now further be described by way of particular embodiments and examples, the invention not being limited thereto.

A first particular embodiment relates to a method of manufacturing a dual work function device as described above wherein the step of providing a first metal layer 108 comprising at least a first work function tuning element over the first gate electrode 102a further comprises the steps of providing a patterned first metal layer wherein said first metal layer 108 covers at least the first gate electrode 102a in the first region 101a but not the second gate electrode 102b in the second region 101b.

In a second particular embodiment said step of providing a patterned first metal layer may comprise depositing the first metal layer 108 covering the first gate electrode 102a in the first region 101a and the second gate electrode 102b in the second region 101b and patterning the first metal layer 108 hereby removing part of the first metal layer in the second region 101b covering the second gate electrode 102b.

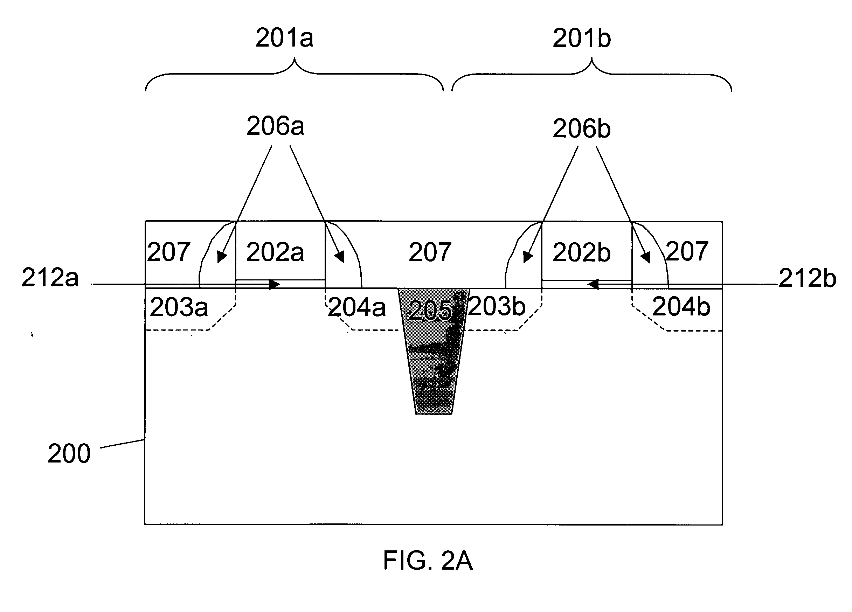

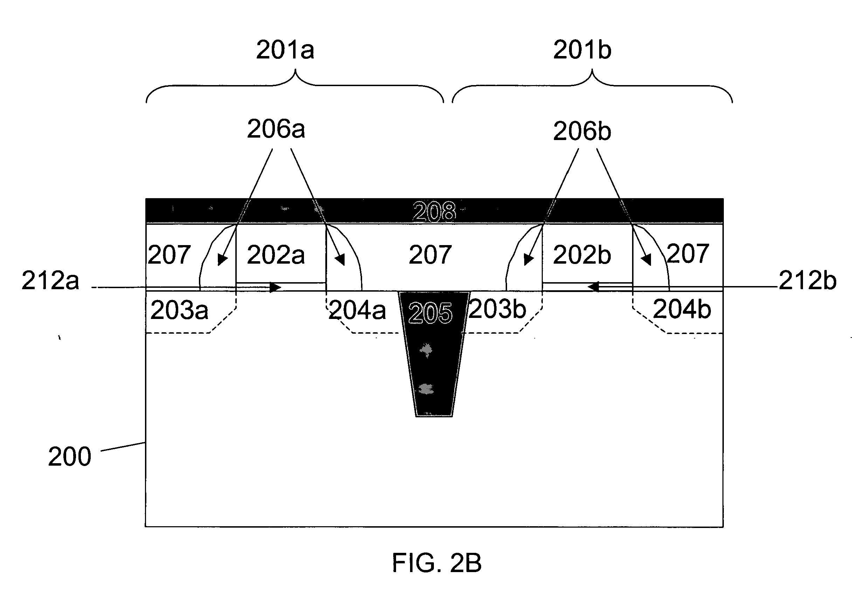

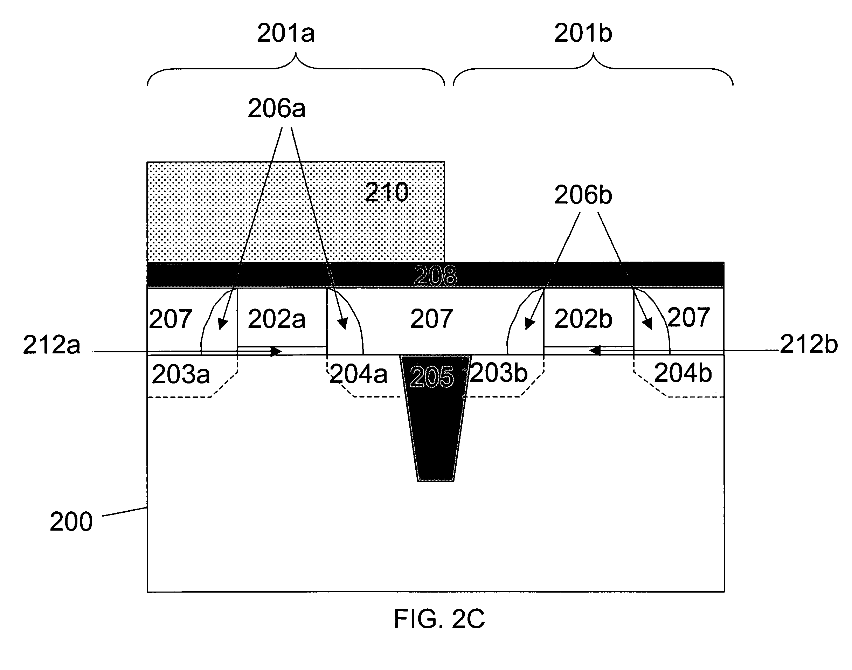

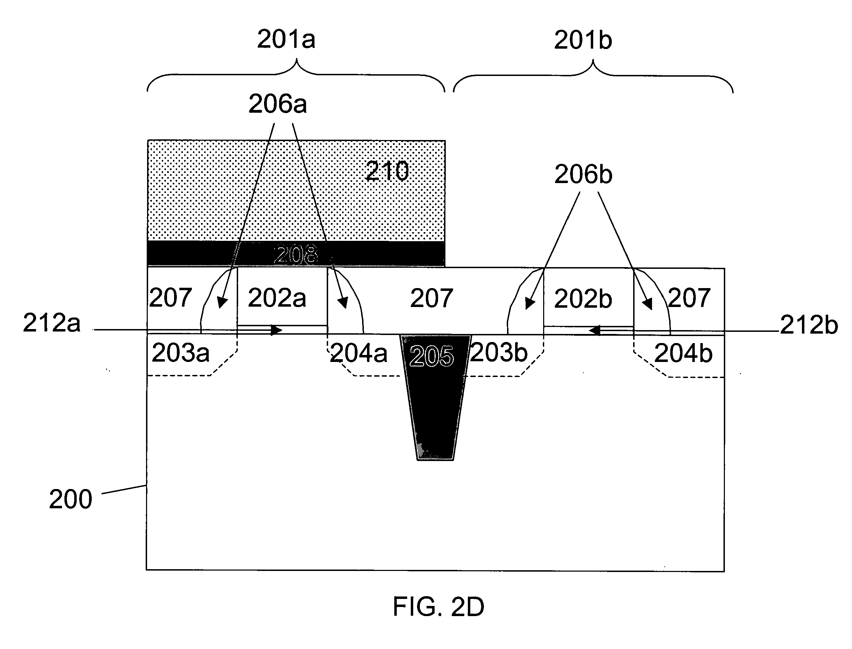

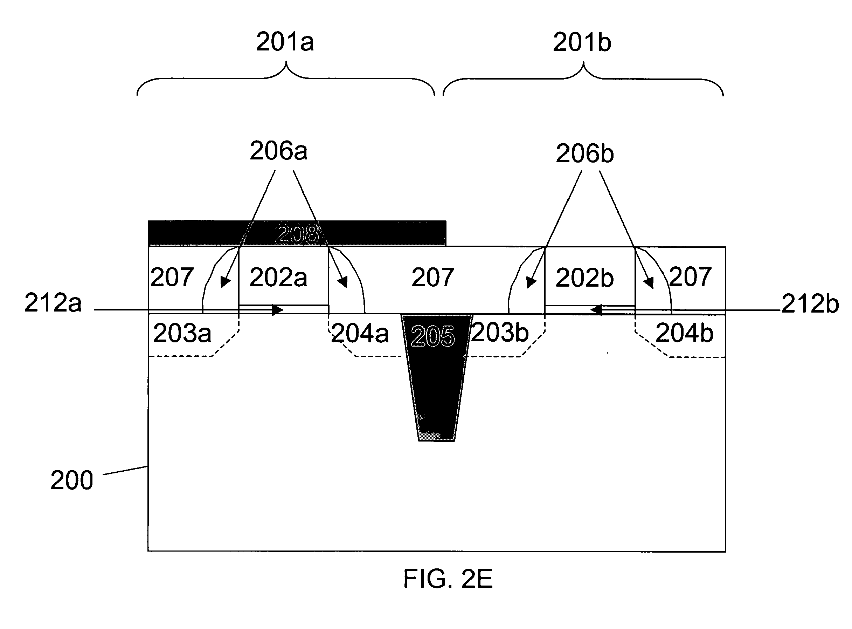

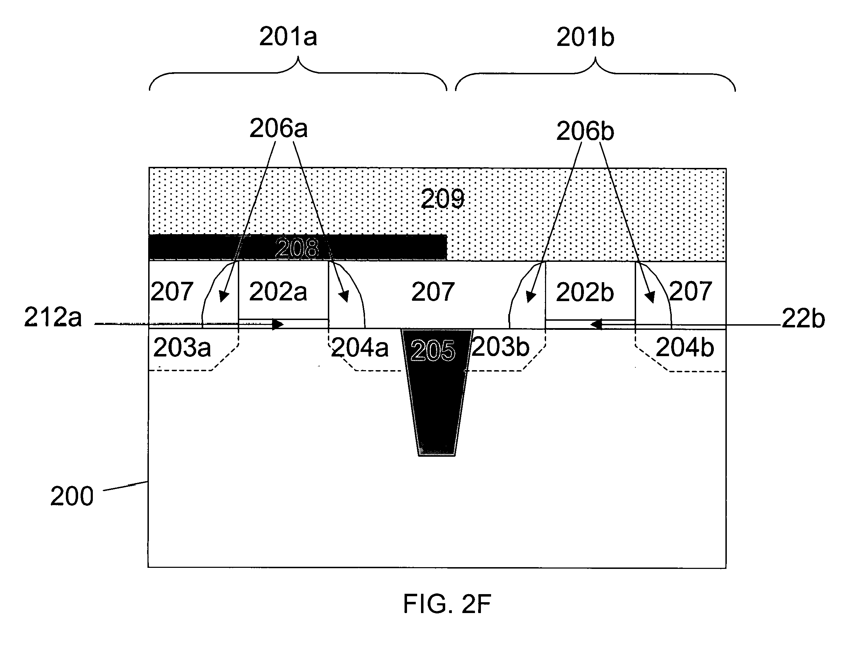

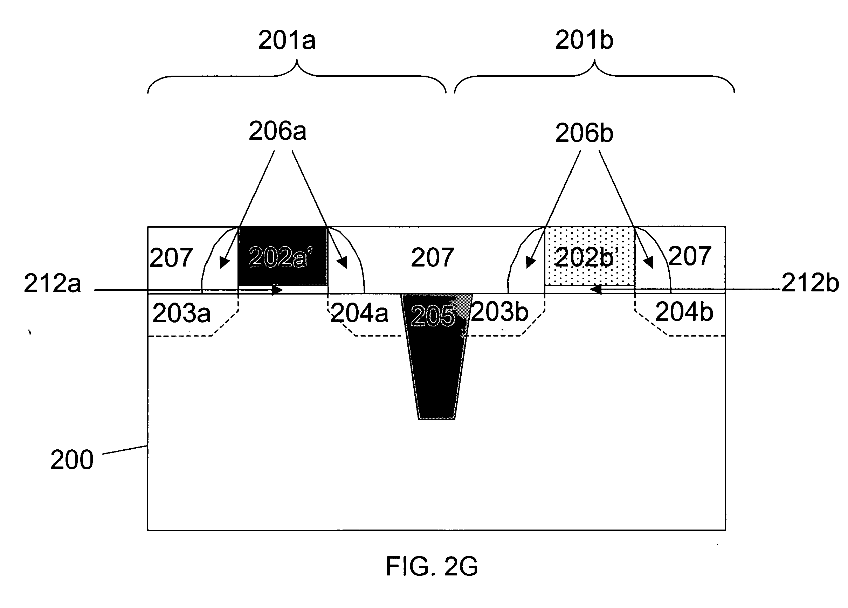

Figure 2 (FIG. 2A-2G) shows an example according to embodiments of the present invention. After the steps of defining at least a first region 201a and at least a second region 201b in a substrate 200; providing a first gate electrode 202a, a first source 203a and a first drain 204a region in the first region 201a; providing a second gate electrode 202b, a second source 203b and a second drain 204b region in the second region 201b as described above (FIG. 2A) a first metal layer 208 is provided over at least the first gate electrode 202a and over at least the second gate electrode 202b, more specifically over the first region 201a and over the second region 201b (FIG. 2B).

Before the step of providing a first metal layer 208 over the first region 201a and over the second region 201b, additionally spacers 206a 206b may be formed in the first region 201a and/or in the second region 201b (FIG. 2A). Spacers are formed from an insulating material such as for example silicon dioxide (SiO₂), silicon nitride (SiN) or silicon oxynitride (SiON). Spacers may be deposited by CVD and patterned by anisotropic etching.

Before the step of providing a first metal layer 208 over the first region 201a and over the second region 201b, additionally an insulating layer 207 may be formed on both first 201a and second 201b region (FIG. 2A). More specifically the insulating layer 207 is formed above the first and second source 203a 203b/drain 204a 204b regions and planar with the first 202a and second 202b gate electrodes. The insulating layer may comprise preferably oxide such as for example silicon oxide (SiOₓ). The insulating layer may also be nitride such as for example silicon nitride (SiN) or silicon oxynitride (SiON). The insulating layer may be preferably formed using a deposition technique such as for example chemical vapor deposition (CVD). Alternatively the insulating layer may be an etch stop layer (ESL). The insulating layer will prevent the source and drain regions from silicidation during the subsequent silicidation steps.

The first metal layer 208 is deposited over at least the first gate electrode 202a and over at least the second gate electrode 202b, more specifically over the first region 201a and over the second region 201b. The first metal material must be present over at least the first gate electrode in order to perform the silicidation of the first gate electrode in a later step. The first metal material 208 is preferably deposited by a vapour deposition technique such as for example physical vapour deposition (PVD). Alternatively electron-beam deposition may be used.

The first metal layer comprises at least a first metal and at least a first work function tuning element. The first metal comprises at least a suitable metal for silicidation, such as for example Ni or Co. The first metal may be a refractory metal such as tungsten (W), a noble metal such as platinum (Pt), a near-noble metal such as nickel (Ni), a transition metal such as titanium (Ti), or any combination thereof. A refractory metal comprises any of tungsten (W), molybdenum (Mo), niobium (Nb), tantalum (Ta) or rhenium (R). A noble metal comprises any of for example tantalum (Ta), platinum (Pt), rhodium (Ro),.... A transition metal comprises any of for example titanium (Ti), palladium (Pd), Iridium (Ir),...

Additionally the first metal material may comprise also at least a first work function tuning element, i.e. an element suitable for tuning the work function of the first gate electrode. If both a first metal and a first work function tuning element are present in the first metal layer 108, the first metal layer is also referred to as being a metal alloy. The first metal layer (208) may thus comprise a metal alloy such as for example Ni:Yb, Ni:Pt,... The first work function tuning element in the metal alloy is chosen depending on the majority carriers in the first 201a and/or second 201b region. If for example the first region 201a represents the NMOS region of the semiconductor device the first metal layer may be a metal alloy comprising typically a suitable metal for silicidation, such as for example Ni, and an element from the lanthanides group suitable for tuning the work function of the gate electrode such as for example Yb (Ni:Yb), or for example Ni and Tb (Ni:Tb), Ni and Gb (Ni:Gb), Ni and La (Ni:La), Ni and Er (Ni:Er), Ni and Dy (Ni:Dy),... By choosing the appropriate metal combination the work function of the gate electrode in the NMOS region may be tuned to a low work function, i.e. smaller than 4.75 eV. Depending on the requirements for the threshold voltage Vₜ, the work function may be tuned to be preferably smaller than about 4.6 eV, or preferably smaller than about 4.5 eV, or preferably smaller than 4.4 eV. If for example the first region 201a represents the PMOS region of the semiconductor device the first metal layer may be a metal alloy comprising for example Ni and Pd (Ni:Pd), Ni and Al (Ni:Al), Ni and Pt (Ni:Pt), Ni and Ir (Ni:Ir),... Also other metals form the platinum group, such as Ru, Rh, Os are possible candidates. By choosing this metal combination the work function of the gate electrode in the PMOS region may be tuned to a high work function, i.e. higher than 4.75 eV. Depending on the requirements for the threshold voltage Vₜ, the work function may be tuned to be preferably higher than about 4.8 eV, or preferably higher than about 5 eV, or preferably higher than 5.1 eV.

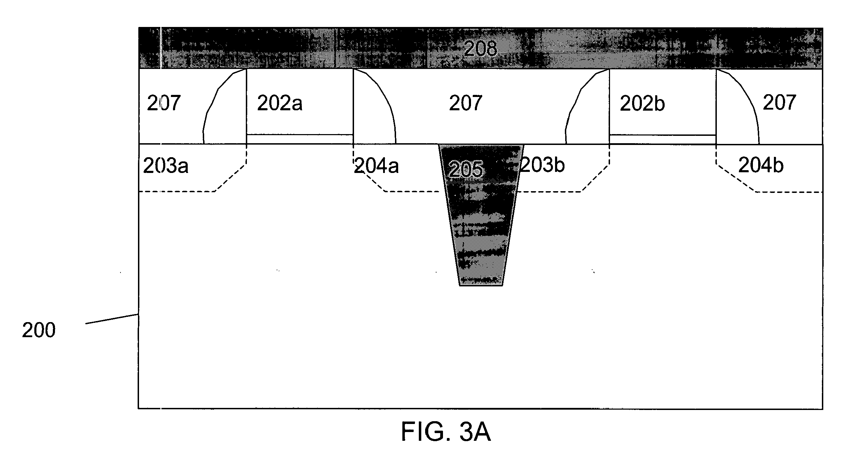

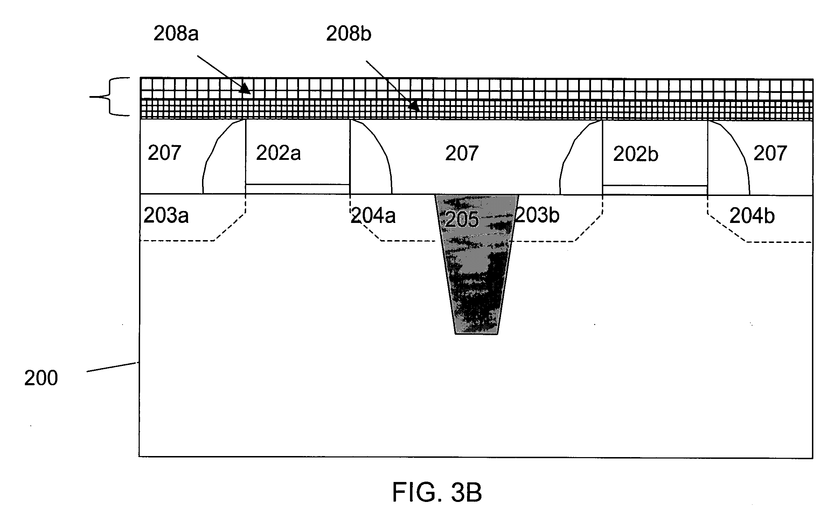

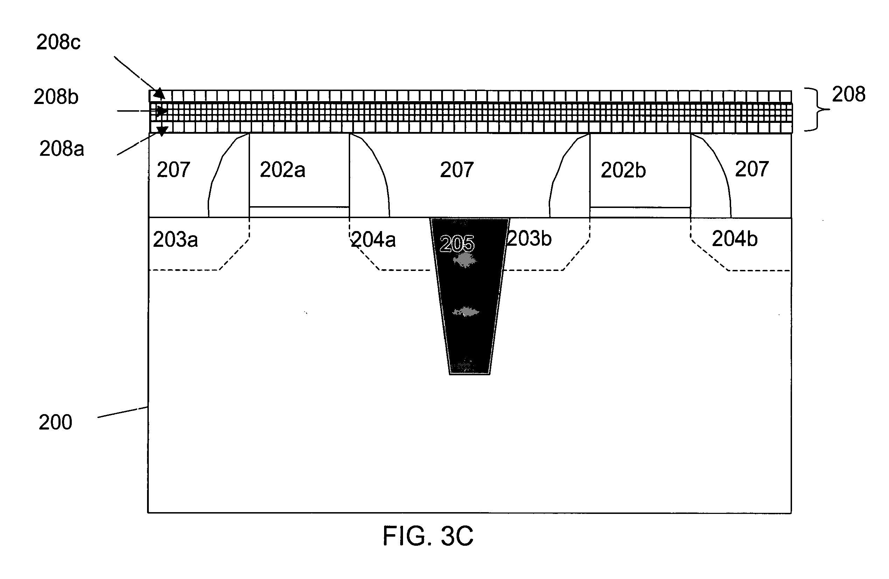

The thickness of the first metal layer 208 is preferably smaller than 30 nm, preferably smaller than 10 nm, typically between 5 and 30 nm. The first metal layer 208 may be obtained for example by physical vapor deposition, i.e. by sputtering the first metal from a target on a substrate. If the first metal material comprises a metal alloy (e.g. Ni:Yb), i.e. a first metal and at least a first work function tuning element, the metal alloy may be deposited by sputtering from one target comprising the desired composition of the alloy (e.g. Ni:Yb) on the substrate. The metal alloy may also be deposited for example by sputtering the separate metals from the metal alloy from their respective targets on the substrate. The first metal layer thus comprises only one layer comprising the metal alloy. Alternatively the first metal layer 208 may be in the form of a stack of layers, i.e. at least two layers deposited on top of each other. Such a layer stack may be formed by sequentially sputtering the different layers. For example, the first metal material 208 may comprise a layer of Yb and a layer of Ni formed on top of the layer of Yb. The thickness of the individual layers of the layer stack determines the amount of the different metals. Also the ratio of the layer thickness determines the ratio of the different materials (e.g. Ni/Yb ratio). For example a Ni:Yb alloy may be formed with 50% of nickel (Ni) and 50% of ytterbium (Yb). Figure 3 (FIG. 3A-3C) shows different examples for depositing the first metal layer 208 over the first region 201a and over the second region 201b. In FIG. 3A the first metal layer 208 consists of one layer comprising a metal (e.g. Ni) or a metal alloy (e.g. Ni:Yb). In FIG. 3B the first metal layer 208 consists of a layer stack with two metal layers 208a 208b, for example one layer comprising Ni 208a and one layer comprising Yb 208b. If the thickness of the first metal layer 208 is for example 20 nm, the thickness of the layer comprising for example Ni may be 10 nm and the thickness of the layer comprising for example Yb may be also 10 nm. In this example the first metal layer 208 thus comprises 50% Ni and 50% Yb. In FIG. 3C the first metal layer 208 consists of a layer stack with three metal layers 208a 208b 208c, for example one layer comprising Yb 208b sandwiched between two layers of Ni 208a 208c. If the thickness of the first metal layer 208 is for example 20 nm, the thickness of the layer comprising for example Yb may be 10 nm and the thickness of the two layers comprising for example Ni may be 5 nm each. In this example the first metal layer 208 thus comprises 50% Ni (divided over two layers) and 50% Yb. The thickness of the first metal layer may also depend on the height of the gate electrode. The thickness of the first metal layer must be thick enough in order to fully siliced the gate electrode material during the subsequent silicidation steps. The higher the gate electrode, the more metal material, thus the thicker the metal layer needed to fully silicide the gate electrode.

After the step of depositing the first metal layer 208 over the first region 201a and over the second region 201b, the first metal layer 208 is patterned wherein the first metal layer 208 over the second gate electrode 202b, more specifically over the second region 201b is removed. This means that after this step the first metal layer 208 is only present in the first region 201a and not in the second region 201b. This is shown schematically in FIG. 2E. Thus the first metal layer 208 will only react with the underlying first gate electrode 202a in the first region 201a during the silicidation step and will not react with the second gate electrode 202b in the second region 201b.

In an embodiment of the invention, the step of patterning the first metal layer 208 may comprise the steps of providing a photoresist layer 210 on the first metal layer 208, performing a lithographic step whereby removing the photoresist layer 210 covering the second region 201b and etching the first metal layer 208 in the second region 201b. This step of patterning the first metal layer 208 is shown schematically in FIG. 2C and FIG. 2D. In FIG. 2C a photoresist material 210 is deposited over the first metal layer 208 and part of the photoresist material 210 in the second region 201b is removed after performing a lithographic step. After this lithographic step the first metal material 208 is still present on both the first region 201a and the second region 201b. In FIG. 2D the first metal layer 208 in the second region 201b is removed by an etching step using the remaining photoresist material 210 as a hardmask. The etching step is selective towards the gate electrode material 202b in the second region 201b and/or the dielectric material 207 and/or the spacer material 206b. A wet etching step may preferably be used for removing the first metal layer 208 in the second region 201b. In a next step the photoresist material 210 in the first region 201a is removed for example by etching. The etching is preferably a wet etching step selective to the first metal layer 208. The step of stripping the photoresist material 210 is shown schematically in FIG. 2E.

After the step of providing a first metal layer 208 over only the first region 201a, a second metal layer 209 is formed over the first metal layer 208 in the first region 201a and over the second region 201b. This step is shown schematically in FIG. 2F.

The second metal layer 209 comprises at least a second metal or at least a metal alloy. With metal alloy is meant that the second metal layer comprises at least a second metal and at least a second work function tuning element. The second metal comprises at least a suitable metal for silicidation, such as for example Ni or Co. The second metal may be a refractory metal such as tungsten (W), a noble metal such as platinum (Pt), a near-noble metal such as nickel (Ni), a transition metal such as titanium (Ti), or any combination thereof. A refractory metal comprises any of tungsten (W), molybdenum (Mo), niobium (Nb), tantalum (Ta) or rhenium (R). A noble metal comprises any of for example tantalum (Ta), platinum (Pt), rhodium (Ro),.... A transition metal comprises any of for example titanium (Ti), palladium (Pd), Iridium (Ir),...

Additionally the second metal layer may comprise also a work function tuning element, i.e. a metal suitable for tuning the work function of the gate electrode. The second metal layer 209 may also comprise a metal alloy such as for example Ni:Yb, Ni:Pt,... The second work function tuning element 209 is chosen depending on the majority carriers in the first 201a and/or second 201b region. If for example the second region 201b represents the NMOS region of the semiconductor device the second metal layer may be a metal alloy comprising typically a suitable metal for silicidation, such as for example Ni, and an element from the lanthanides group suitable for tuning the work function of the gate electrode such as for example Yb (Ni:Yb), or for example Ni and Tb (Ni:Tb), Ni and Gb (Ni:Gb), Ni and La (Ni:La), Ni and Er (Ni:Er), Ni and Dy (Ni:Dy),... By choosing the appropriate metal combination the work function of the gate electrode in the NMOS region may be tuned to a low work function, i.e. smaller than 4.75 eV. Depending on the requirements for the threshold voltage Vₜ,, the work function may be tuned to be preferably smaller than about 4.6 eV, or preferably smaller than about 4.5 eV, or preferably smaller than 4.4 eV. If for example the first region 201a represents the PMOS region of the semiconductor device the first metal layer may be a metal alloy comprising for example Ni and Pd (Ni:Pd), Ni and Al (Ni:Al), Ni and Pt (Ni:Pt), Ni and Ir (Ni:Ir),... Also other metals form the platinum group, such as Ru, Rh, Os are possible candidates. By choosing this metal combination the work function of the gate electrode in the PMOS region may be tuned to a high work function, i.e. higher than 4.75 eV. Depending on the Vₜ requirement, the work function may be tuned to be preferably higher than about 4.8 eV, or preferably higher than about 5 eV, or preferably higher than 5.1 eV.

The first metal from the first metal layer 208 and the second metal from the second metal layer 209 may comprise the same metal. If for example the first region 201a represents the NMOS region of the semiconductor device the first metal layer may be a metal alloy, such as for example Ni:Yb, thus containing a first metal and at least a frist work function tuning element in order to tune the work function of the first gate electrode 202a in NMOS region. In the second region 201b, which is the PMOS region of the semiconductor device, a second metal layer may be deposited whereby the second metal is the same as the first metal. Thus in the PMOS region, for example a Ni layer may be deposited as well as a metal layer (Ni) comprising a second work function tuning element, for example Pt. In the NMOS region Ni:Yb may be used for tuning the first gate electrode and in the PMOS region Ni:Pt may be used for tuning the work function of the second gate electrode. Alternatively the first metal layer 208 and the second metal layer 209 may comprise a different first and second metal, such as for example Ni for the NMOS region and Co for the PMOS region. Alternatively different combinations are possible: a metal for the NMOS region, a metal alloy for the PMOS region or a metal alloy for the NMOS region, a metal for the PMOS region or a metal alloy for both NMOS and PMOS region,...

The thickness of the second metal layer 209 is preferably in the range of 30 nm to 120 nm.

Alternatively a poly etch back may be performed of the gate electrode. This means that part of the gate electrode is etched. During the step of forming a second metal layer, the second metal material will also be present in part of the gate electrode which is etched back. By this way it is possible to get, after the silicidation step, a gate electrode which is rich of the second metal material.

After the step of providing the second metal layer a first silicidation is performed of the first gate electrode 202a in the first region 201a and a second silicidation is performed of the second gate region 202b in the second region 201b, whereby the first and second silicidation step are performed simultaneously. This step is shown schematically in FIG. 2G. The silicidation step comprises a least one annealing process during which the first 202a and second 202b gate electrode are transformed simultaneously respectively at least partially in a first 202a' and second 202b' metallic silicided gate electrode. The first silicidation and the second silicidation step are done in one occurring step. The temperature of the annealing process is in a range of about 350°C to 600°C, preferably in a range of about 350°C to 550°C. The duration of the annealing process is in a range of about 30s to 90s, preferably in a range of about 30s to 60s. The annealing process is preferably performed in N2 or Ar at 1atm.. The annealing step is preferably a rapid thermal processing step (RTP). Alternatively two annealing steps may be performed for transforming the first and/or second gate electrode respectively into a first and/or second metallic silicided gate electrode. Preferably the first annealing step (e.g. RTP1) is done at a lower temperature compared to the second annealing step (e.g. RTP2). During the first annealing step only the top part of the first and/or second gate electrode is converted respectively into a first and/or second metallic silicided gate electrode. After the first annealing step the unreacted metal is removed and the second annealing step is performed at a higher temperature compared to the first annealing step to further convert the first and/or second gate electrode respectively into a first and/or second metallic silicided gate electrode. The first annealing step is performed simultaneously for both the first gate electrode and the second gate electrode. The second annealing step is performed simultaneously for both the first gate electrode and the second gate electrode.

The at least one annealing step is done simultaneously for the first 202a and/or second 202b gate electrode. With simultaneously is meant that the first 202a and/or second 202b gate electrode are annealed at the same time and thus converted at the same time into a metallic silicided gate electrode. With simultaneously is meant that the silicidation of the first gate electrode 102a and of the second gate electrode 102b is performed at the same time. Otherwise said this means that the silicidation of the first gate electrode 102a and of the second gate electrode 102b is not formed in subsequent steps but during one occurring step. For example if the first metal layer 208 is Ni and the second metal layer 209 is Ni:Pt, the first gate electrode 202a is converted in NiSi and the second gate electrode 202b is converted in NiSi:Pt during the same silicidation step.

Preferably the first 202a and/or second 202b gate electrode are completely transformed. Otherwise said this means that substantially the complete first 202a and/or second 202b gate electrode is converted respectively into a first 202a' and/or second 202b' metallic silicided gate electrode, resulting in a so-called first and/or second fully silicided gate electrode (FUSI).

It is an advantage of certain embodiments that the silicidation of both gate electrodes can be performed during one silicidation step.

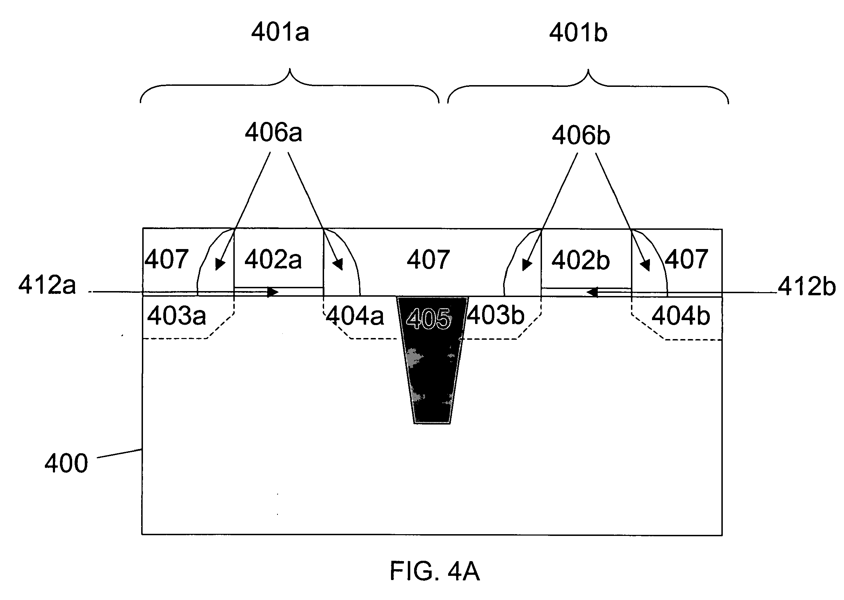

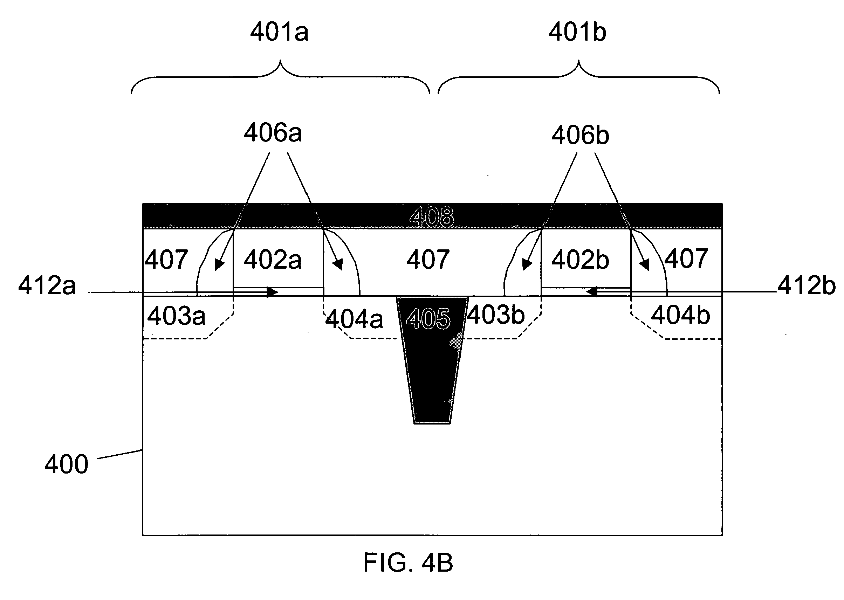

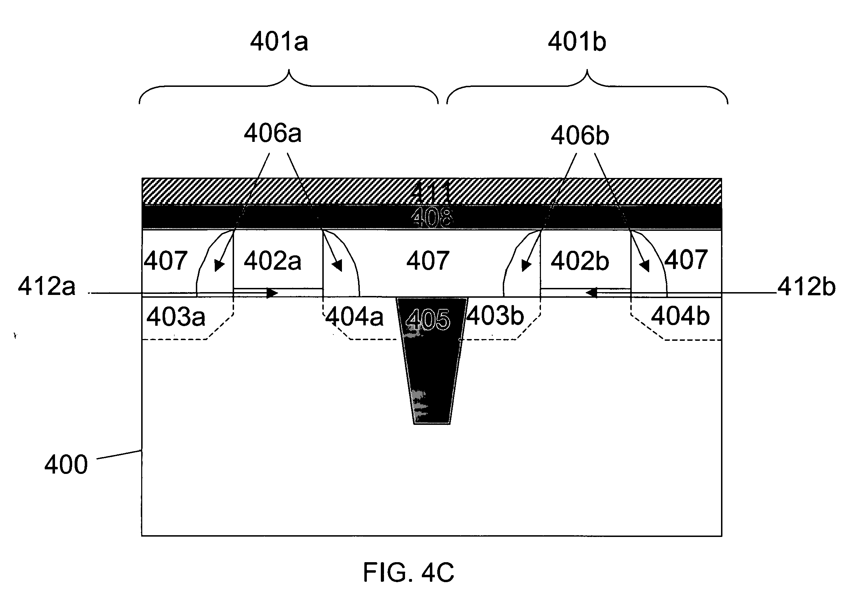

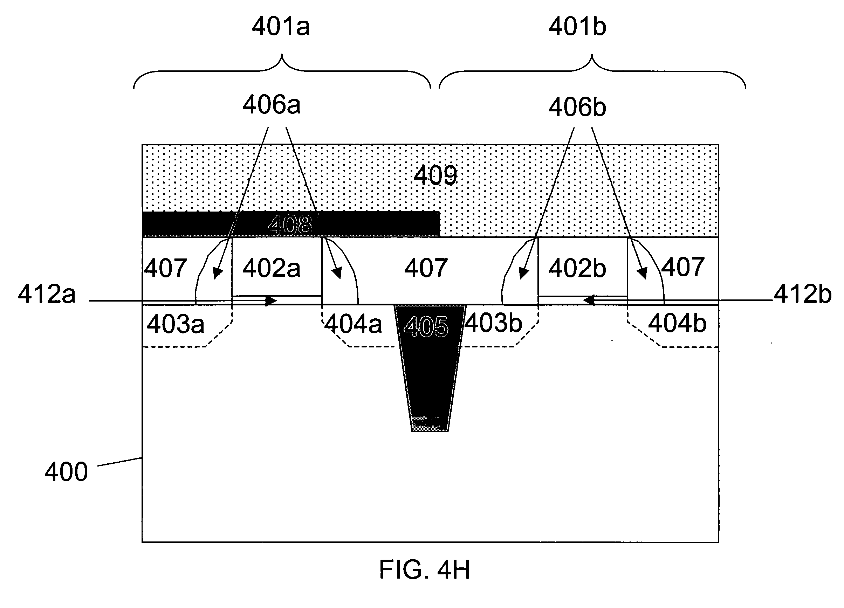

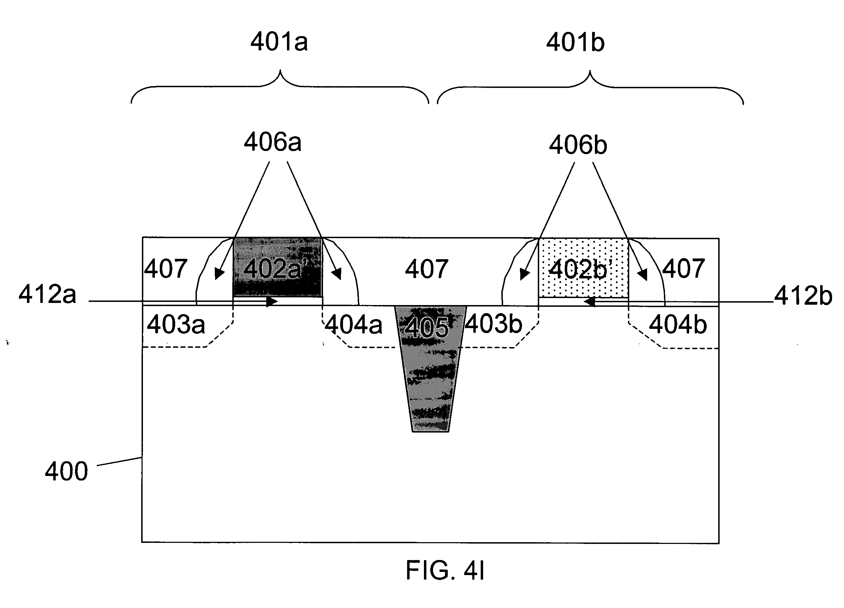

Another particular embodiment relates to a method of manufacturing a semiconductor device as described above further comprising the steps of providing a hardmask layer on the first metal layer before the step of providing a photoresist layer and etching part of the hardmask layer in the second region covering the second gate electrode before the step of removing part of the first metal layer. After the steps of defining at least a first region 401a and at least a second region 401b in a substrate 400 (FIG. 4A), providing a first gate electrode 402a and a first source 403a and a first drain 404a region in the first region 401a (FIG. 4A), providing a second gate electrode 402b and a second source 403b and a second drain 404b region in the first region 401b (FIG. 4A), providing an insulating layer 407 to prevent the source and drain regions of being silicided (FIG. 4A), providing a first metal layer 408 over covering the first electrode 402a in the first region 401a and the second electrode 402b in the second region 401b (FIG. 4B) as also described above, a hardmask material 411 is provided on the first metal layer 408 (FIG. 4C).

The hardmask material 411 may comprise an oxide, a metal, Ge, SiGe and may be deposited using a vapour phase deposition technique such as for example PVD or any other deposition technique known for a person skilled in the art.

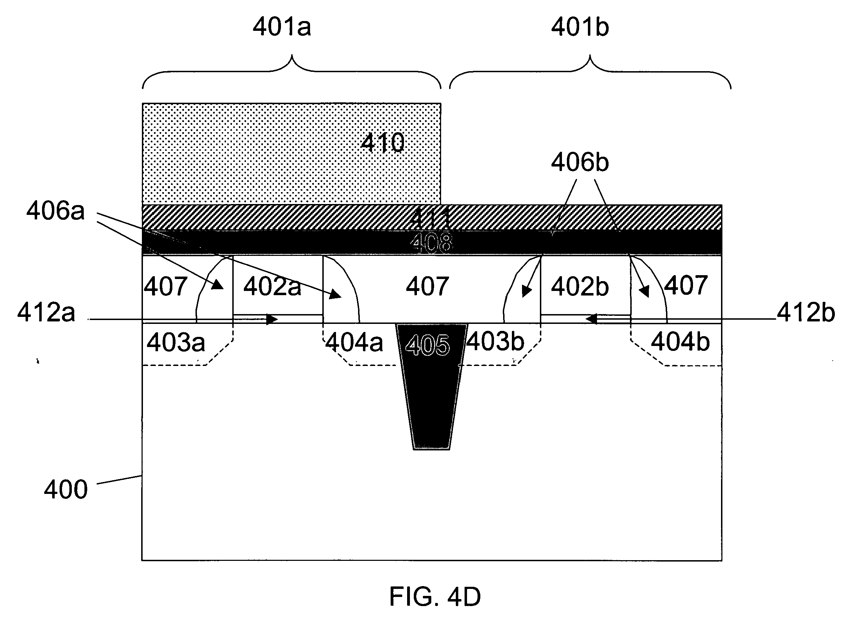

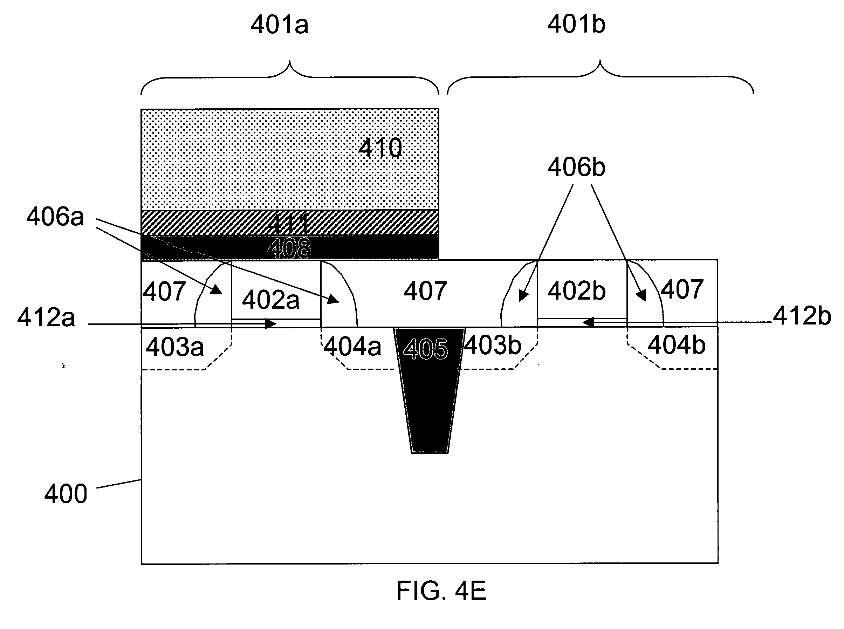

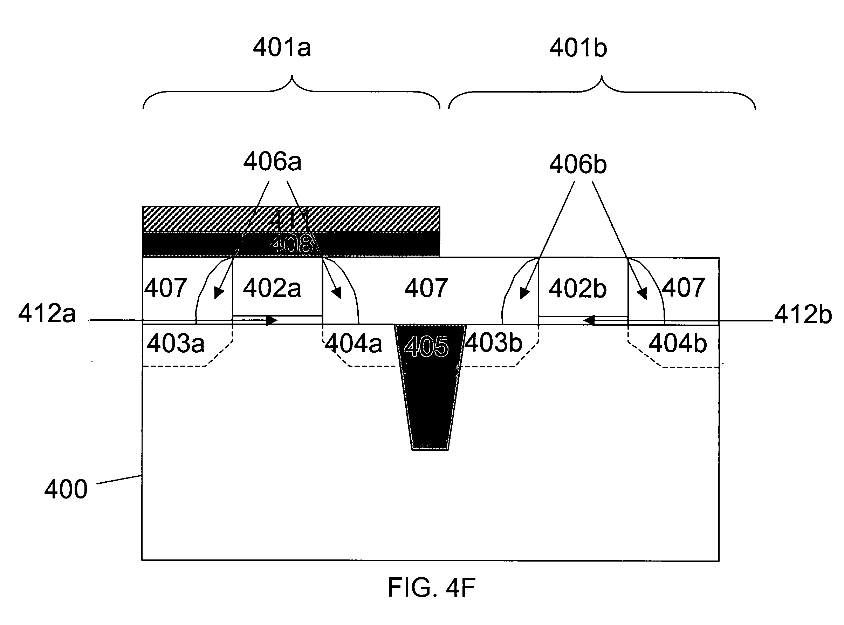

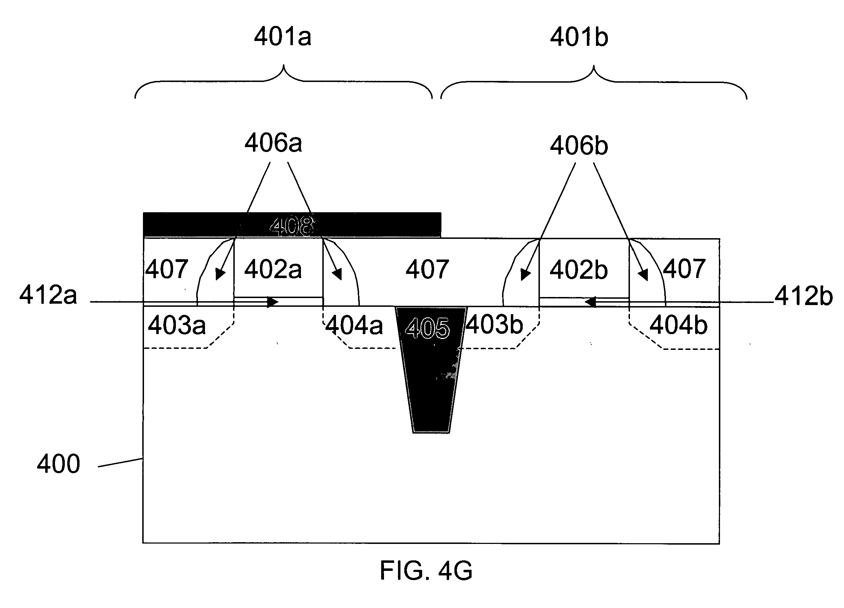

In a next step after providing the hardmask material 411 a photoresist layer 410 is formed on the hardmask material 411. After performing a lithographic step, part of the photoresist layer 410 on the second region 401b is removed. At this point the first metal layer 408 and the hardmask layer 411 are present on both the first region 401a and the second region 401b, while the photoresist layer 410 is only present on the first region 401a (FIG. 4D), or at least on the first gate electrode 402a. Next the hardmask layer 411 in the second region 401b is etched using a standard etching method known for a person skilled in the art. After etching the hardmask layer 411, also the first metal layer 408 in the second region 401b is removed (FIG. 4E). After the step of etching the hardmask layer 411 and etching the first metal layer 408 in the second region 401b, the hardmask material and the metal material should at least not be present on the second gate electrode 402b. After removal of the first metal layer 408 in the second region 401b, the photoresist layer 410 (FIG. 4F) and the hardmask layer 411 (FIG. 4G) are removed. It is an advantage of the particular embodiment that the photoresist layer 410 can be stripped without damaging the underlying first metal layer 408, since the hardmask layer 411 is sandwiched in between the photoresist layer 410 and the first metal layer 408.

After the step of removing the photoresist layer 410 and the hardmask layer 411 the second metal layer is formed and further steps are provided as already described above according to an embodiment of the present invention (FIG. 4G-4I).

Alternatively only the photoresist layer 410 may be removed in the first region 401a. The hardmask layer 411 is thus not removed in the first region 401a. After the step of providing the second metal layer, the hard mask material 411 will be sandwiched in between the first metal layer 408 and the second metal layer 409 in the first region 401a. An advantage of keeping the hard mask material 411, otherwise said of not removing the hard mask material 411, is to prevent that the second metal material 409 interacts with the first metal material 408 during the subsequent silicidation step. If the hard mask material 411 is removed before the step of forming the second metal layer 409, it could be possible that during the subsequent silicidation step the second metal and/or the second work function tuning element could interact with the first metal and/or the first work function tuning element of the first metal layer 408.

Another particular embodiment relates to a method of manufacturing a dual work function semiconductor device as described above wherein the step of providing a patterned first metal layer over the first region further comprises providing a sacrificial layer covering at least the first electrode and the second electrode, patterning the sacrificial layer such that the patterned sacrificial layer covers at least the second electrode but not the first electrode, providing a first metal layer in the first region covering at least the first electrode and covering at least the patterned sacrificial layer in the second region covering the second electrode and patterning the first metal layer.

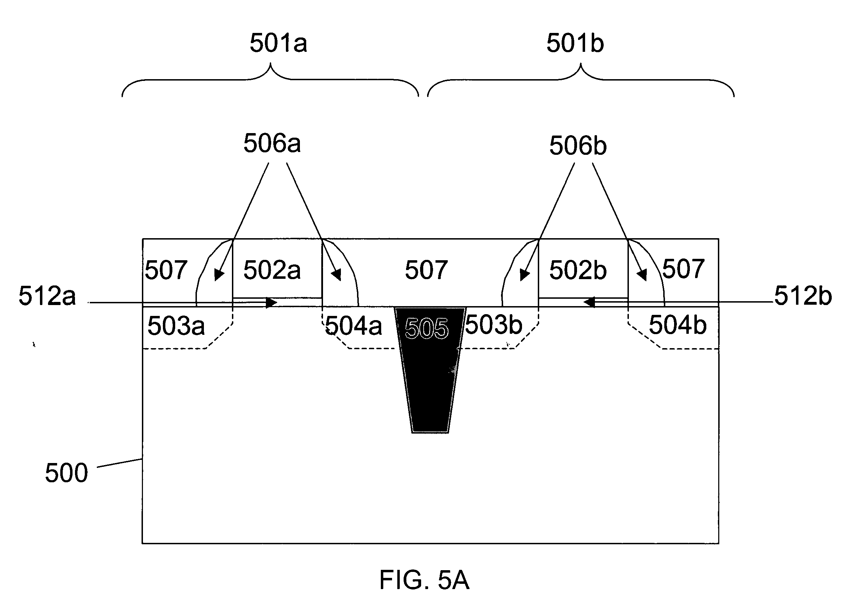

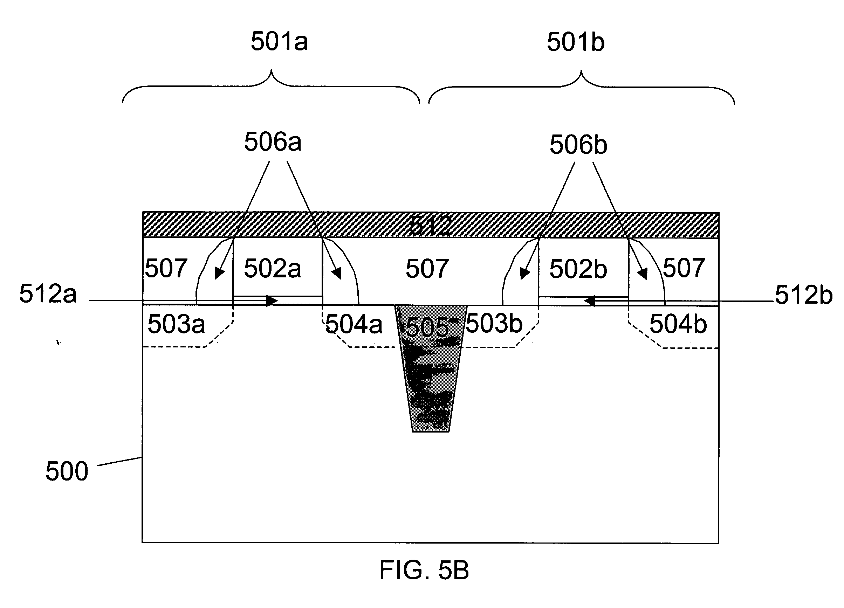

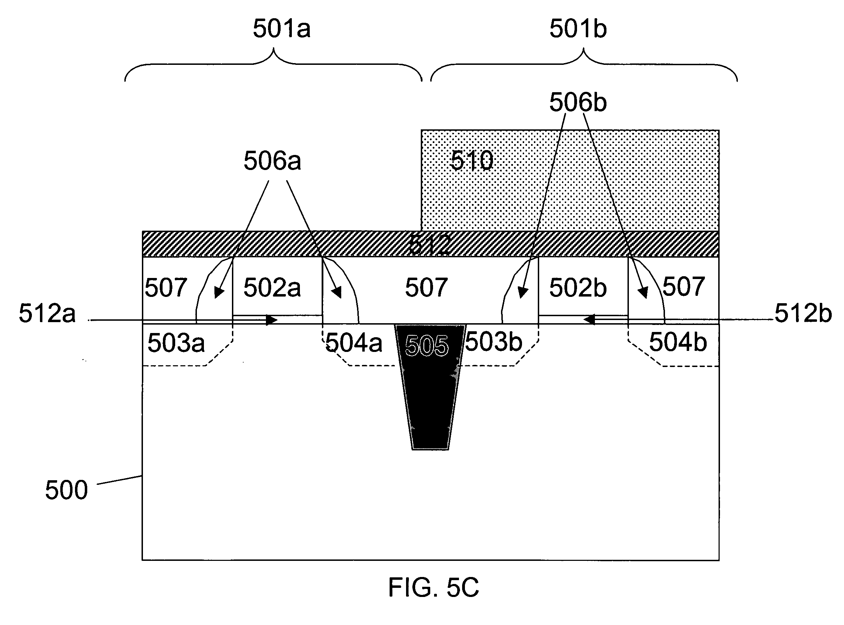

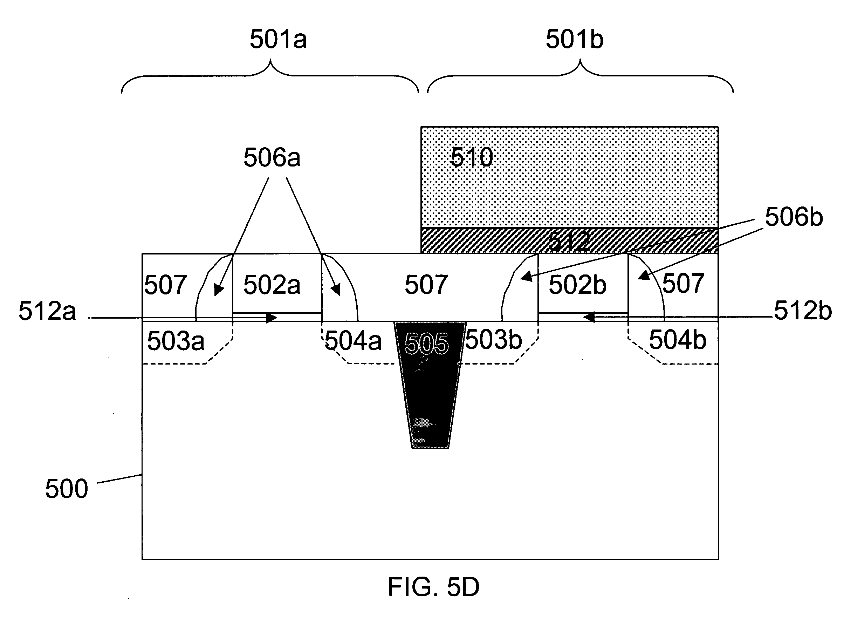

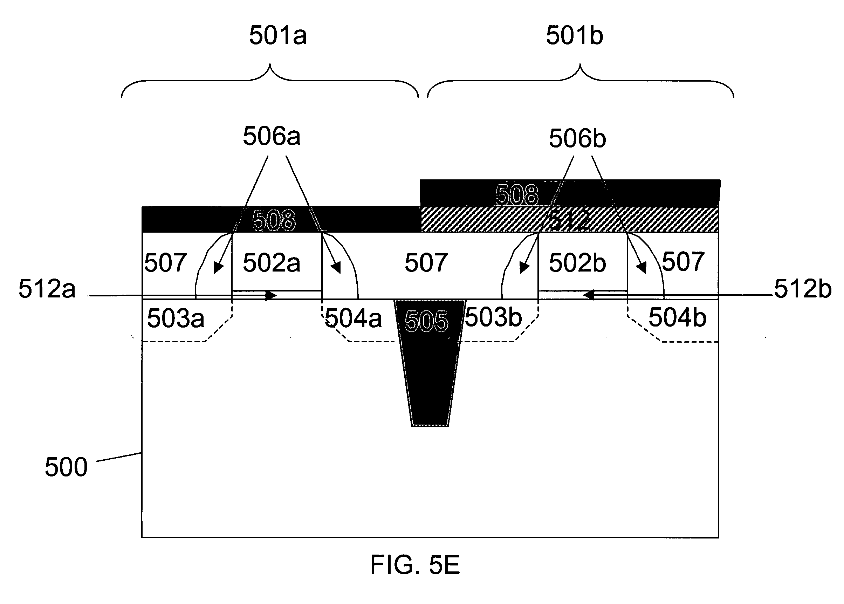

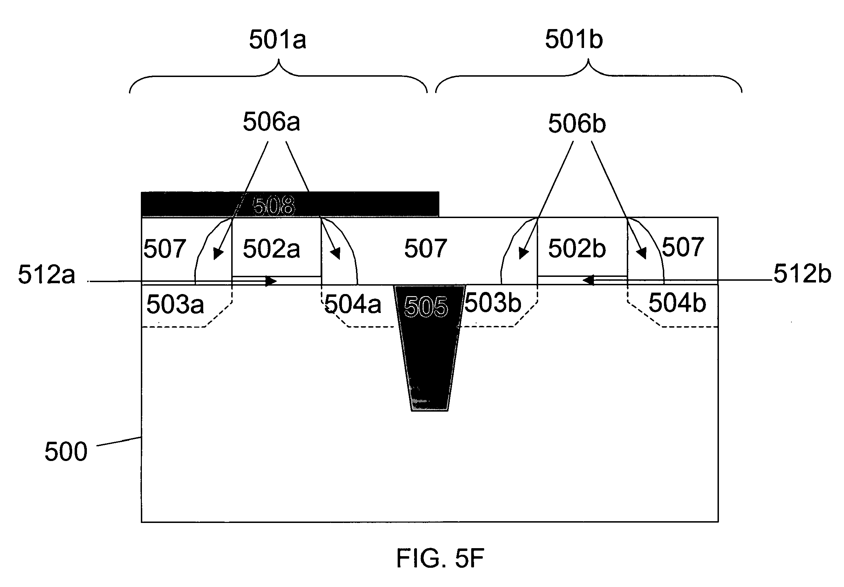

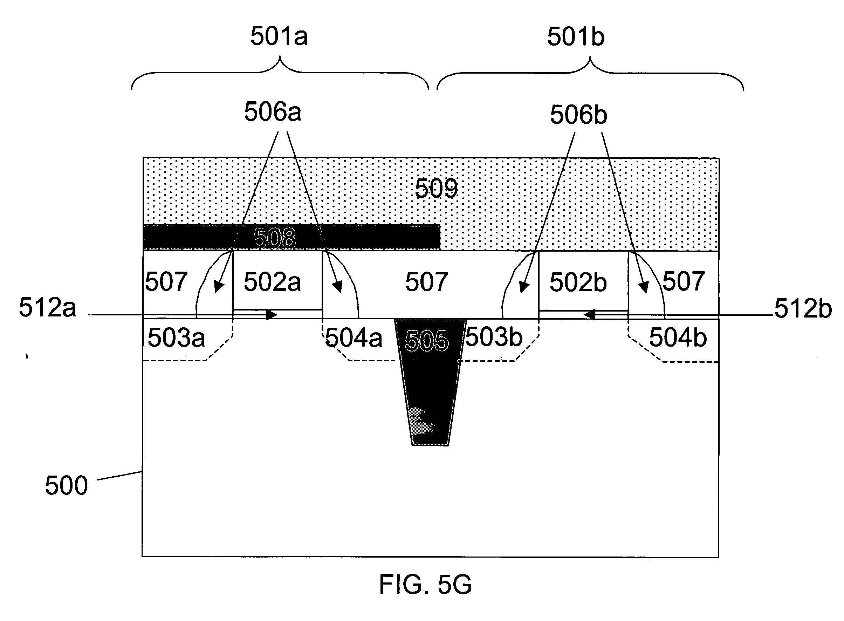

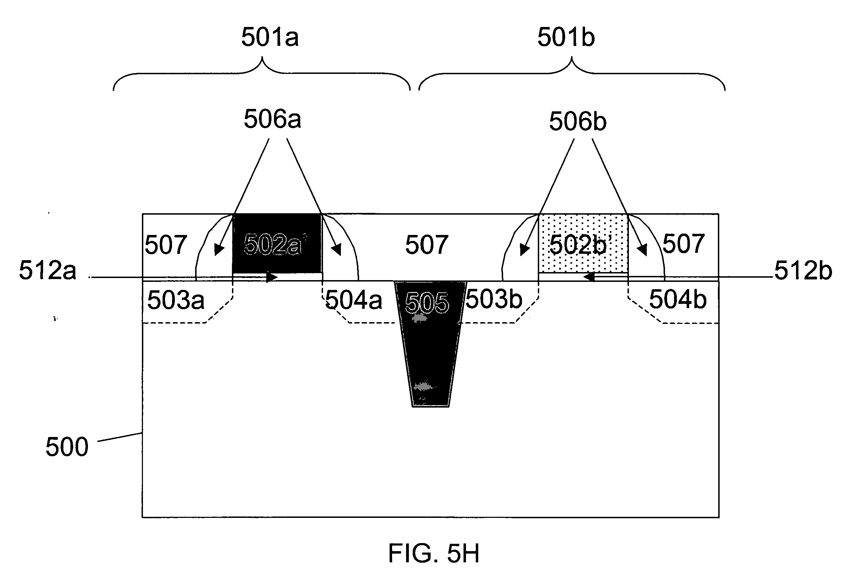

The different steps of this particular embodiment are shown schematically in FIG. 5 (FIG. 5A-5H). After the steps of defining at least a first region 501a and at least a second region 501b in a substrate 500 (FIG. 5A), providing a first gate electrode 502a and a first source 503a and a first drain 504a region in the first region 501a (FIG. 5A), providing a second gate electrode 502b and a second source 503b and a second drain 504b region in the first region 501b (FIG. 5A), providing an insulating layer 507 to prevent the source and drain regions from silicidation (FIG. 5A) as also described above, a sacrificial layer 512 is provided on both the first 501a and the second 501b region (FIG. 5B). The sacrificial layer may comprise for example amorphous carbon, SiGe, TiN and may be provided using PVD, CVD or ALD. Next the sacrificial layer 512 is patterned such that part of the sacrificial layer 512, more specifically the sacrificial layer in the first region 501a or at least the sacrificial layer on the first gate electrode 502a, is removed. The patterning step can be performed by depositing a photoresist layer 510 on the sacrificial layer 512, performing a lithographic step whereby removing part of the photoresist layer 510 in the first region 501a (FIG. 5C) and etching the sacrificial layer using the photoresist layer 510 in the second region 501b as a mask. In this way the sacrificial layer 512 in the first region 510a is removed (FIG. 5D). The removal of the sacrificial layer 512 can be performed for example by etching the sacrificial layer 512.. After this step of removing the sacrificial layer 512 also the photoresist is stripped. The sacrificial layer 512 is thus only present in the second region 501b. Next the first metal layer 508 is provided on the first region 510a and the second region 510b. In the first region 510a the first metal layer 508 is thus directly formed on at least the first gate region 502a. The first metal layer may also be present and in contact with the dielectric material 507. In the second region 501b the first metal layer 508 is thus formed on and in contact with the sacrificial layer 512 (FIG. 5E). Next the sacrificial layer 512 may be lift-off in the second region 501b whereby also the first metal layer 508 in the second region 501b is removed simultaneously during the lift-off step (FIG. 5F). The lift-off process may be for example etching with a dilute ammonium hydroxide (NH₄ OH) and peroxide (H₂ O₂) mixture (APM) when a sacrificial layer is formed of for example amorphous carbon or Ge. Depending on the material properties of the sacrificial layer a more appropriate etching chemistry known to a person skilled in the art may be chosen. After this step, the first metal material 508 is only present in the first region 501a. Subsequent steps of providing the second metal material 509 (FIG. 5G) and performing a simultaneous silicidation of the first gate region 502a and the second gate region 502b are performed as described above in particular embodiments of the present invention.

The first metal layer and the second metal layer may comprise at least a first and second metal respectively for silicidation of the electrode. Additionally the first metal layer and/or the second metal layer may comprise at least a first and at least a second work function tuning element for tuning the work function of the underlying gate electrode. Additionally other materials may be provided in the first and/or second metal layer. Such a metal alloy may comprise for example Ni for silicidation, Yb as work function tuning element and for example an additional material such as P.

Alternatively tuning of the work function may be performed by implanting a work function tuning element into the polysilicon gate prior to silicidation. The metal layer will then comprise only a first metal necessary for silicidation of the electrode. Work function tuning of the gate electrode by using implantation of work function tuning element into the polysilicon electrode may be used for at least the first region or at least the second region and may be combined by using a metal or metal alloy in the metal layer of the at least second or first region respectively. Both electrodes will be silicided during a simultaneous silicidation step. For example the first electrode may be implanted with Yb before the step of providing a first metal layer. Said first metal layer may comprise for example Ni, which is suitable for silicidation. After providing a first metal layer a second metal layer may be provided in the second region comprising at least a second metal, for example Ni or another metal suitable for silicidation, and alternatively also at least a second work function tuning element, for example Pt. In a next step a simultaneous silicidation is performed of the first and second electrode. The work function of the electrode in the first region may thus be tuned by the implanted Yb in the gate electrode, whereas the work function of the electrode in the second region may be tuned by the work function tuning element added in the second metal alloy. Alternatively, the work function of the first electrode in the first region may be tuned by a first work function element added in the first metal layer and the work function of the second electrode in the second region may be tuned by implanting the second electrode with a work function tuning element.

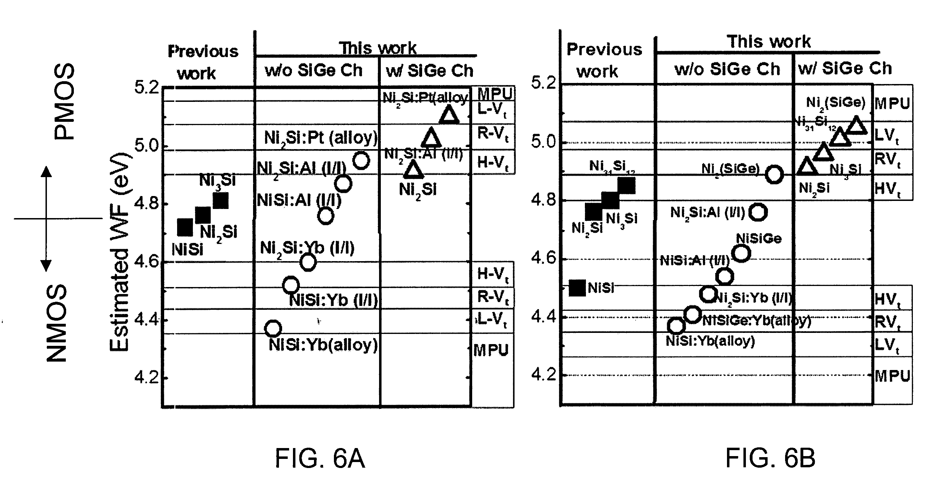

FIG. 6 shows two examples of experimental results using embodiments according to present invention. For both NMOS and PMOS different metals are used for tuning the work function of the gate electrode FIG. 6A shows the results of the estimated work function for both NMOS and PMOS with SiON as gate dielectric material. FIG. 6B shows the results of the estimated work function for both NMOS and PMOS with HfSiON as gate dielectric material. For NMOS Ni:Yb is used as first metal material. After silicidation the NMOS polysilicon gate electrode is thus converted into NiSi:Yb. By implanting Yb into the polysilicon prior to silicidation, the work function of the gate electrode can be tuned to about 4.5 eV (NiSi:Yb I/I). By silicidation using a metal alloy Ni:Yb (NiSi:Yb alloy) a lower work function of the silicided metal gate electrode can be achieved with a value of about 4.35 eV. For PMOS Ni:Al and Ni:Pt are used as first metal material. After silicidation the NMOS polysilicon gate electrode is thus converted into NiSi:Al or NiSi:Pt respectively. By implanting Al into the polysilicon prior to silicidation the work function of the gate electrode can be tuned to about 4.9 eV (NiSi:A1 I/I). By silicidation using a metal alloy Ni:Pt (NiSi:Pt alloy) a higher work function of the silicided metal gate electrode can be achieved with a value of about 5.0 eV.

It is an advantage of certain embodiments that the work function of the gate electrode can be modulated in a much wider range by using an alloy approach, which comprises performing a simultaneous silicidation step for siliciding the first gate electrode using a first metal material or metal alloy and for siliciding the second gate electrode using a second metal material or metal alloy. The first and second metal material are chosen such that the work function of the gate electrode may be tuned to a higher or lower work function depending on the majority carriers of the device. Tuning of the work function is done by choosing the appropriate work function tuning element.
In a dual work function CMOS device, the at least first region may be n-type doped (i.e. NMOS) and the at least second region may then be oppositely doped, namely p-type doped (i.e. PMOS). For the first NMOS region the first metal layer may comprise a first metal suitable for silicidation of the polysilicon gate electrode and may comprise additionally a first work function tuning element able to tune the work function. Tuning the work function for an NMOS region means lowering said work function. For the second PMOS region the second metal layer may comprise a second metal suitable for silicidation of the polysilicon gate electrode and may comprise additionally a second work function tuning element able to tune the work function. Tuning the work function for a PMOS region means making said work function higher. Said first metal and second metal may be the same, but may also be different. Said first work function tuning element for NMOS will be different from said second work function tuning element for PMOS, since PMOS and NMOS require different work functions.

## Claims

1. Method of manufacturing a dual work function semiconductor device comprising:
- providing at least a first region (101a) in a semiconductor substrate (100) comprising at least a first electrode (102a);
- providing at least a second region (101b) in the semiconductor substrate (100) comprising at least a second electrode (102b);
- providing a first metal layer (108) over the first electrode (102a) in the first region (101a), the first metal layer comprising at least a first metal and at least a first work function tuning element;
- providing a second metal layer (109) in the second region (101b) at least over the second electrode (102b), the second metal layer (109) comprising at least a second metal;
- performing a first silicidation of the first electrode (102a) and performing a second silicidation of the second electrode (102b) wherein the first silicidation and the second silicidation are performed simultaneously.

2. Method of manufacturing a dual work function semiconductor device according to claim 1 wherein the second metal layer further comprises at least a second work function tuning element, the second work function tuning element being different from the first work function tuning element.

3. Method of manufacturing a dual work function semiconductor device according to claim 1 or 2 wherein the first metal and the second metal are the same.

4. Method of manufacturing a dual work function semiconductor device according to any of claims 1 to 3 wherein the step of providing a first metal layer comprises providing a patterned first metal layer covering at least the first electrode in the first region but not covering the second electrode in the second region.

5. Method of manufacturing a dual work function semiconductor device according to claim 4 , wherein the step of providing a patterned first metal layer comprises:
- depositing a first metal layer covering the first electrode in the first region and the second electrode in the second region;
- patterning the first metal layer hereby removing part of the first metal layer in the second region covering the second electrode.

6. Method of manufacturing a dual work function semiconductor device according to claim 5, wherein patterning the first metal layer comprises:
- providing a photoresist layer covering the first electrode in the first region and the second electrode in the second region after the step of depositing a first metal layer;
- performing a lithographic step hereby removing at least part of the photoresist layer covering the second electrode in the second region and
- etching the first metal layer in the second region at least covering the second electrode.

7. Method of manufacturing a dual work function semiconductor device according to claim 6, further comprising:
- before providing a photoresist layer providing a hardmask layer on the first metal layer and
- etching part of the hardmask layer in the second region covering the second electrode before etching the first metal layer.

8. Method of manufacturing a dual work function semiconductor device according to claim 4 , wherein the step of providing a patterned first metal layer (108) comprises:
- providing a sacrificial layer (112) covering at least the first electrode (102a) in the first region and the second electrode (102b) in the second region;
patterning the sacrificial layer (112) such that the patterned sacrificial layer (112) covers at least the second electrode (102b) in the second region but not the first electrode (102a) in the first region;
- providing a first metal layer (108) covering the first electrode (102a) in the first region and covering the patterned sacrificial layer (112) covering the second electrode (102b) in the second region; and
- patterning the first metal layer(108).

9. Method of manufacturing a dual work function semiconductor device to claim 8, wherein patterning the sacrificial layer (112) comprises:
- providing a photoresist layer (110) on the sacrificial layer (112) covering the first electrode (102a) in the first region and the second electrode (102b) in the second region;
- performing a lithographic step, hereby removing part of the photoresist layer (110) in the first region at least covering the first electrode(102a); and
- removing part of the sacrificial layer (112) in the first region at least covering the first electrode (102a).

10. Method of manufacturing a dual work function semiconductor device according to claim 8 or 9, wherein patterning the first metal layer (108) further comprises lifting off the sacrificial layer (112) in the second region covering the second electrode (102b), hereby also removing the first metal layer (108) in the second region covering the second electrode (102b).

11. Method of manufacturing a dual work function semiconductor device according to any of claims 1 to 10, wherein the step of providing a second metal layer comprises covering at least the first electrode and the second electrode with the second metal layer.

12. Method of manufacturing a dual work function semiconductor device according to any of claims 1 to 11, wherein the first and/or the second metal (108, 109) comprises at least a metal from the group of Ni, Co, Ti, and others.

13. Method of manufacturing a dual work function semiconductor device according to any of claims 1 to 12 wherein the first work function tuning element comprises an element from the lanthanide group, or when dependent on claim 2 or any claim depending on claim 2, wherein the second work function tuning element comprises an element from the lanthanide group.

14. Method of manufacturing a dual work function semiconductor device according to claim 13 , wherein the first or second work function tuning element comprises any of Yb, Tb, Gd, La, Er, Dy, and others.

15. Method of manufacturing a dual work function semiconductor device according to any of claims 1 to 12 wherein the first work function tuning element comprises a platinum metal, or when dependent on claim 2 or any claim depending on claim 2, wherein the second work function tuning element comprises a platinum metal.

16. Method of manufacturing a dual work function semiconductor device according to claim 15, wherein the first or second work function tuning element comprises any of Pt, Pd, Ir, Ru, Rh, Os.

17. Method of manufacturing a dual work function semiconductor device according to any of claims 1 to 12 , wherein the first work function tuning element comprises Al or when dependent on claim 2 or any claim depending on claim 2, wherein the second work function tuning element comprises Al.

18. Method of manufacturing a dual work function semiconductor device according to any of the previous claims, the semiconductor device being a CMOS device, wherein the first region and the second region have an opposite doping type.

19. Method of manufacturing a dual work function semiconductor device according to claim 18 wherein the doping type of first region is n-type.
